# EUROPEAN PATENT APPLICATION

(11) **EP 0 708 585 A2**
(43) Date of publication of application: **24.04.1996**
(21) Application number: 95202679.7
(22) Date of filing: 05.10.1995
(51) Int. Cl.: H05K 7/18

(54) **Continuous axially operated joint for connecting flat elements**

(30) Priority: 17.10.1994 IT MI942109; 08.06.1995 IT MI951222
(71) Applicant: SIFE INDUSTRIALE S.p.A., I-Milano (IT)
(72) Inventor: Balzanelli, Vincenzo, I-20149 Milano (IT)
(74) Representative: Raimondi, Alfredo, Dott. Ing. Prof.

(57) **Abstract**

Continuous joint (10, 100, 1000) for connecting flat elements, which is hollow and designed to contain inside it a coaxial sliding member (7), sliding in a longitudinal direction with respect to the profiled member (1), at least one longitudinal eyelet (5, 8) being formed respectively on the surfaces (1a, 1b) of the hollow profiled member (1) provided with said pairs of flanges (2) and on the corresponding surfaces of the sliding member (7), said sliding member (7) having an end female thread (9a) designed to cooperate with an operating screw (10a) for moving said sliding member (7) from a position where the eyelets (5) of the profiled member (1) are aligned, into a non-aligned position where the end surface of the eyelet (8) of the sliding member (7) engages with a corresponding seat (6b) of a cam element (6) projecting from the end (3a) of each panel (3) to be secured to the joint and inserted inside the joint itself.

## Description

The present invention relates to a continuous joint with coaxial elements which can be operated so as to perform a relative translatory movement in the longitudinal direction in order to connect flat elements such as dividing walls, side panels and end sections of furniture and/or containers such as metal cabinets for electrical equipment and the like.

As is known, a lot of electrical equipment such as electric consoles for distributing and/or controlling electrical energy is normally installed inside metal containers in the form of cabinets to be placed on the ground, wall-mounted or inset, provided with a door which can be opened and one or more internal compartments. At present many types of cabinets for these purposes are provided with a fixed structure which is predetermined during production, while many others are formed by assembling various components such as side panels, top and bottom end sections, removable surfaces and the like, depending on requirements.

In the particular case of containers with modular and pre-formed walls, assembly of the said elements is performed by means of various fixing systems such as pins or screws; these fixing systems require the boring of holes in predetermined positions on the elements, resulting in the undesirable weakening of the component parts, in addition to requiring long assembly times and a high degree of precision during production.

In other cases, assembly of the pre-formed walls of the container is performed using separate elements forming force-fitting joints which can be inserted into the box-shaped ends formed in the side panels and end sections; said force-fitting joints normally consist of block-shaped bodies with two or more pairs of parallel flanges which are inserted into said cavities of the adjacent walls to be connected.

A particular joint suitable for the assembly of rigid box-shaped frames enclosing a panel for forming the flanks and opposite end sections of the container is also known from EP 0,569,087 in the name of the same Proprietor; this joint consists of a quandrangular profiled member with a length equal to that of the sides of the frame and provided, on at least two adjacent and mutually perpendicular faces, with a pair of straight and parallel flanges with a length equal to that of the box-shaped profiled member itself, which can be inserted in a concealed manner inside corresponding cavities formed longitudinally on the sides of the flanks and the end sections, stable fixing between the joints and walls being obtained by means of screws passing transversely through the cavities present on the sides of the flanks and end sections and tightened on blocks with threaded holes interposed and retained for each pair of parallel flanges emerging from the box-shaped joint.

This embodiment in practice has a certain structural complexity and presents difficulties as regards tightening of the screws which are located inside the cavities of the sides of the frames, in positions which are difficult for the assembler to reach.

The technical problem which is therefore posed is that of providing a joint for connecting walls of furniture or cabinets, dividing walls and the like which are box-shaped at least peripherally, said joint being structured so as to eliminate the drawbacks of the known joints used in the assembly of side panels and end sections and also being designed to reduce drastically the number of relative fixing points of the side panels and end sections which need to be adjusted in order to fix the same.

Within the scope of this problem, a further aim of the present invention is to provide a joint designed to allow rapid and easy assembly of side panels and end sections, using a single operating point which can be accessed externally for alignment and simultaneous clamping, along their entire length, of the side panels with one another and with the end sections, so as to allow rapid and easy assembly and disassembly of the container.

Another aim of the invention is to provide a joint which has hinging means designed to effect a coupling between two elements which are able to rotate relative to one another about a fixed axis so as to form for example doors and/or multi-stage cabinets which can be opened.

These and other further aims which can be understood more clearly from the description which follows, are achieved by a continuous joint for connecting flat elements, such as dividing walls and/or side panels and/or end sections, of furniture and/or metal containers and the like, comprising a profiled member, at least two adjacent surfaces of which have a pair of parallel flanges extending perpendicularly with respect to the faces of the profiled member and along the entire length thereof, wherein said profiled member is hollow and designed to contain inside it a coaxial sliding member, sliding in a longitudinal direction with respect to the profiled member, at least one longitudinal eyelet being formed respectively on the surfaces of the hollow profiled member with said pairs of flanges and on the corresponding surfaces of the sliding member. Said sliding member has an end female thread designed to cooperate with an operating screw for moving the sliding member itself from a position where the eyelets thereof and the eyelets of the profiled member are aligned, into a non-aligned position where the surface of one end of the eyelet of the sliding member engages with a corresponding seat of a cam element projecting from the end of each panel to be secured to the joint and inserted in the joint itself.

Further characteristic features of the present invention are described in the following detailed description, with reference to the accompanying drawings, in which:
Figure 1 shows an exploded view of a joint according to the invention;
Figure 2 shows a schematic section through the joint according to Figure 1, in the position for locking one end section with a side panel, arranged at 90° with respect to each other;
Figure 3 shows a section along the plane indicated by III-III in Figure 2;
Figures 4a and 4b show a section through a continuous T-shaped joint;
Figures 5a, 5b and 5c show alternative examples of embodiment of the joint according to the invention;
Figure 6 shows an exploded view of an example of embodiment of the joint with a hinge element applied to a container;
Figure 7 shows a schematic section through the joint with the hinge element according to Figure 6 assembled;
Figure 8 shows a section along the plane indicated by VIII-VIII in Figure 7.

With reference to the aforementioned figures, the continuous joint 10 for the assembly of metal cabinets/containers formed by side panels or walls to be secured together and/or with the opposite top and bottom end sections consists of a quandrangular profiled member 1 which is internally hollow and extends along a length corresponding to the width of the walls of the container; a pair of flat and parallel flanges 2 emerges from each of two adjacent and mutually perpendicular faces 1a, 1b of the profiled member 1, said flanges being intended to form means for force-fitting engagement into a continuous quandrangular cavity 3a formed on the end edges of panels 3 having a box-shaped body and forming the sides and the end sections of the container.

The surfaces 1a, 1b of the box-shaped body 1, corresponding to the pairs of parallel flanges 2, have formed in them rectangular longitudinally extending eyelets or openings 5, into which tongues 6 emerging from the said cavity 3 of the panels and lying on a plane parallel to that of the panel itself can be inserted.

Said tongues 6 have a flat design with the external free end such that it defines a flat head 6a substantially in the form of a cam with a recessed seat 6b formed on the side of the tongue itself.

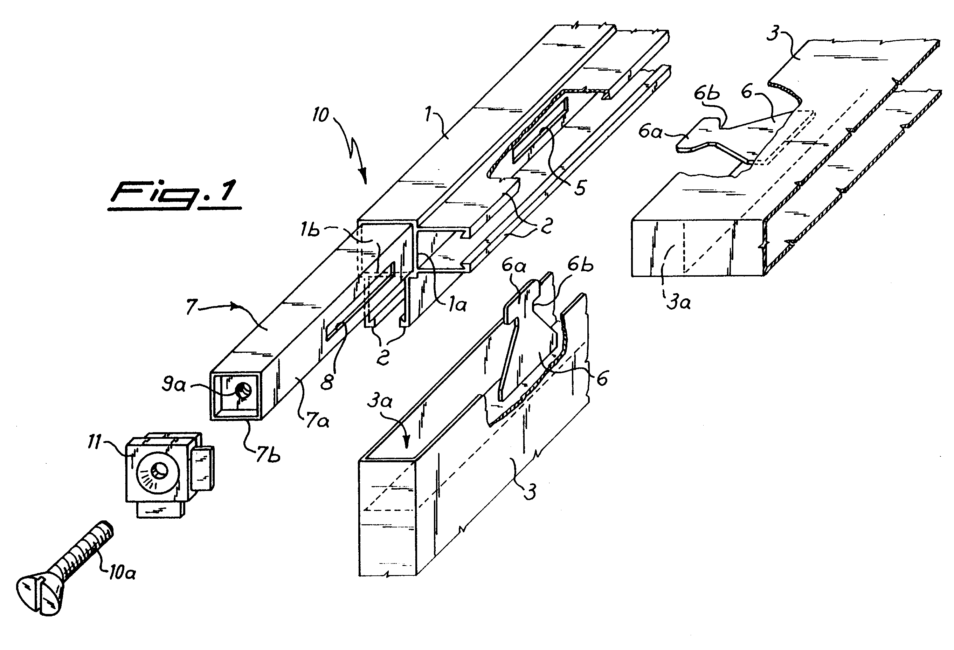

The box-shaped body 1 receives inside it, with a small amount of play, a sliding member 7 consisting of a quadrangular box-shaped body with a length substantially equal to that of the external body 1 and provided in its longitudinal surfaces 7a, 7b, corresponding to the faces 1a, 1b of the body 1, with eyelets 8 which are elongated in the longitudinal direction and have a substantially rectangular shape (Figures 1 and 3) and a length substantially equal to that of the openings 5 of the box-shaped body 1. Said eyelets 8 are formed in a position such as to be located opposite the eyelets 5 of the body 1 when the sliding member 7 is concealingly inserted inside the box-shaped body 1, as illustrated in Figure 2.

Each front end of the sliding member 7 has associated with it a block 9 having a threaded hole 9a in the centre and forming a female thread for engagement with a longitudinal tightening screw 10a passing through a reaction block 11 which can be applied to the end of the box-shaped body 1 (Figures 1 and 2) and is provided with flat extensions 11a parallel to the flanges 2 of the body 1, against which they come into abutment.

Assembly of the walls and/or end sections 3 is obtained by arranging the continuous joint 10 so that the longitudinal openings 8 of the internal sliding member 7 are arranged opposite the associated longitudinal openings 5 of the profiled member 1. In this way, by inserting the cavity 3a of the panels 3 onto the guiding flanges 2 of the surfaces 1a, 1b of the profiled member 1 until it overlaps the extensions 11, the head 6a of the tongues 6 is able to insert itself into the aligned eyelets 5, 8 passing through both the profiled member 1 and the sliding member 7.

At this point, tightening of the screw 10 on the female thread 9a causes sliding of the sliding member 7 with respect to the profiled member 1 until the opposite end of the opening 8 engages in the lateral seat 6b of the head 6a, causing locking and simultaneous alignment of the panel 3 with the continuous joint.

With the aforementioned continuous joint, therefore, by performing externally a single operation via a single operating screw arranged in the longitudinal direction, it is possible to align and at the same time stably lock together the side panels and/or opposite end sections of a container consisting of modular elements.

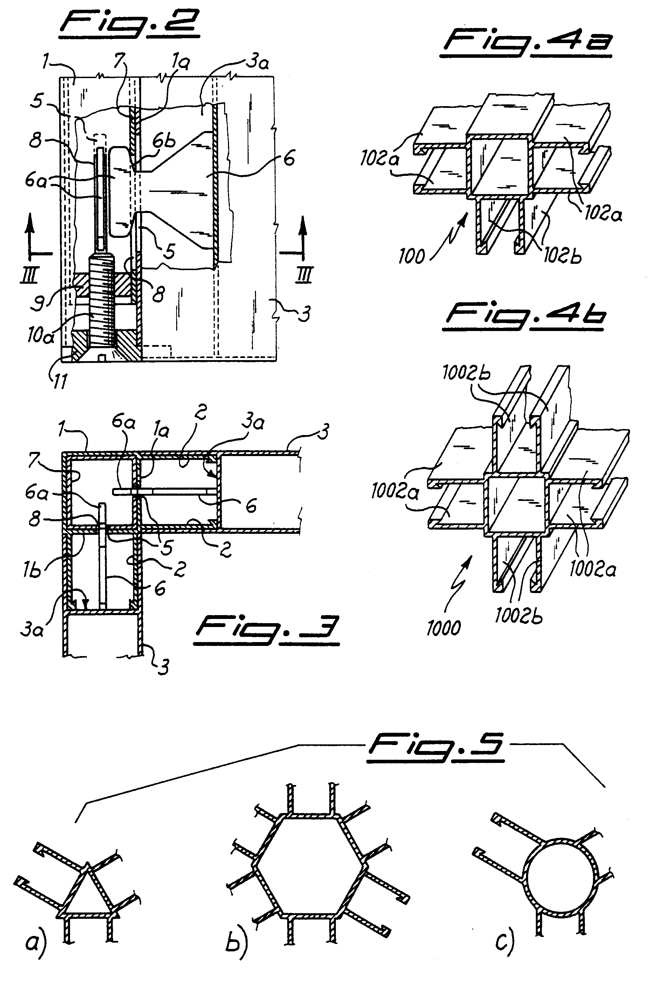

The continuous box-shaped joint 1 according to the invention can also be realized with three or four pairs of flanges arranged at 90° with respect to each other (Figures 4a and 4b) so as to allow panels 3 to be coupled in different directions in order to form containers with a different configuration.

In the case of a container with two adjacent volumes for example, the T-shaped joint 102 (see Figure 4a) will be used, on the opposing flanges 102a (Fig. 4a) of which it is possible to fix two coplanar end sections 3 forming a continuous upper closing surface, while a side panel 3 with the function of a dividing wall can be fixed to the mutually perpendicular flanges 102b; locking of the joint to the three elements associated with the three pairs of flanges 102 is always effected by means of a single longitudinally operated element consisting of the said external screw 10 for traction of the single sliding member 7 sliding inside the hollow body 1 and provided with slots 8 on each coupling side.

Similarly a cross-shaped joint 1000, as illustrated in Figure 4b, can be used in order to construct containers with four adjacent volumes, fixing two coplanar end sections to the horizontal flanges 1002a so as to form an intermediate horizontal surface of the container, and two vertical side panels to the vertical flanges 1002b for the lower volume and for the raised area.

In this case also, by means of a single sliding member sliding inside the body 1a and a single tensioning screw it is possible to perform stable locking of the side panels in the vertical direction and of the end sections in the horizontal direction.

Finally, the head of each tightening screw 10 can be provided with a means having an eyelet or hook, of the fixed or adjustable type, designed to allow raising and transportation of the container without the danger of loosening of the locked arrangement of the various components of the container itself.

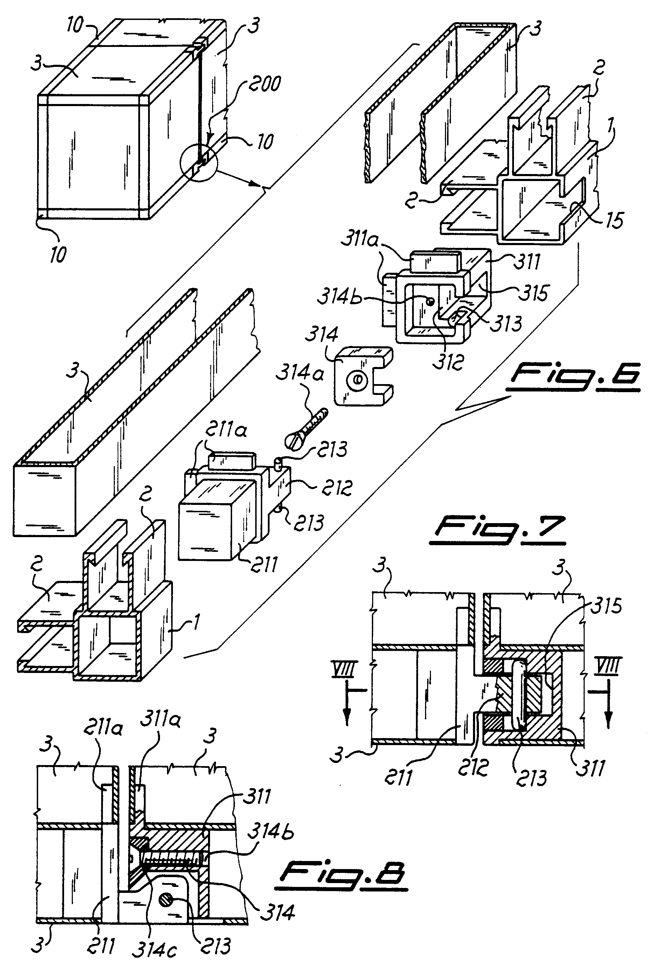

As illustrated in Figures 6 to 8, the joint according to the invention also has a hinge element 200 which allows hinging of two joint sections 10 relative to one another for the formation of doors and the like.

More particularly, said hinge element 200 comprises a first front-end block 211 similar to the block 11 and provided with flat extensions 211a parallel to the flanges 2 of the body 1; said block 211 has an arm 212, extending in the axial direction, on which the hinging pin 213 is provided, being arranged in the transverse direction with respect to the axial direction of the joint.

Said pin 213 and arm 212 are designed for coupling with corresponding seats 312 and 313 of a second block 311 forming the other arm of the hinge, inside which they are locked by means of application of a front closing element axially held in position by means of a screw 314a engaged in a corresponding female thread 314b of the block and retained on it by means of a Seger ring 314c which prevents it from falling during unscrewing.

Both the block 314 and the section of the body 1 inside which it is inserted have formed in them openings 315 and 15, respectively, which, when the hinge is assembled, are located in a corresponding position and allow rotation of the arm 212 about the pin 213 retained in its fixed seat 313 in the block 311.

In practice, the invention as described in a few embodiments thereof may be subject to modifications and variations as regards the structure of the side panels and end sections, the form of the cam heads and the dimensions of the various components, without departing from the protective scope of the invention itself, as described and claimed hereinbelow, for example as in Figures 5a, 5b, 5c which show, respectively, a triangular, hexagonal and circular cross-section of the joint according to the invention.

## Claims

1. Continuous joint (10, 100, 1000) for connecting flat elements such as dividing walls and/or side panels (3) and/or end sections, of furniture and/or metal containers and the like, comprising an internally hollow profiled member (1), at least two adjacent surfaces (1a, 1b) of which have a pair of parallel flanges (2) extending perpendicularly with respect to the faces of the profiled member and along the entire length thereof, characterized in that said profiled member is designed to contain inside it a coaxial sliding member (7), sliding in a longitudinal direction with respect to the profiled member (1), at least one longitudinal eyelet (5, 8) being formed respectively on the surfaces (1a, 1b) of the hollow profiled member (1) provided with said pairs of flanges (2) and on the corresponding surfaces of the sliding member (7), said sliding member (7) having an end female thread (9a) designed to cooperate with an operating screw (10a) for moving said sliding member (7) from a position where the eyelets (8) thereof and the eyelets (5) of the profiled member (1) are aligned, into a non-aligned position where the end surface of the eyelet (8) of the sliding member (7) engages with a corresponding seat (6b) of a cam element (6) projecting from the end (3a) of each panel (3) to be secured to the joint and inserted inside the joint itself.

2. Joint according to Claim 1, characterized in that said screw (10) reacts on a reaction element (11) arranged between the head of the screw itself and the female thread (9a) integral with the sliding member (7).

3. Joint according to Claim 1, characterized in that said rectangular eyelets (5, 8) present on the walls of the profiled member (1) and on the sliding member (7) are three in number, so as to receive and cooperate with the same number of cam heads (6a) emerging from the respective end edges of the panels (3) to be secured.

4. Joint according to Claim 1, characterized in that said parallel and straight flanges are present on three sides of the profiled member (1) so as to form a T-shaped joint.

5. Joint according to Claim 1, characterized in that said flanges are present on four faces of the profiled member so as to form a cross-shaped joint.

6. Joint according to the preceding claims, characterized in that an eyelet or hook or other gripping means for raising and moving the assembled container is provided on the head of each tensioning screw.

7. Joint according to Claim 1, characterized in that it has a substantially triangular cross-section.

8. Joint according to Claim 1, characterized in that it has a substantially hexagonal cross-section.

9. Joint according to Claim 1, characterized in that it has a substantially circular cross-section.

10. Joint according to Claim 1, characterized in that it comprises a hinge element (200) designed to allow relative hinging of two joint sections (10) for the formation of doors and the like.

11. Joint according to Claims 1 and 10, characterized in that said hinge element (200) comprises a first front-end block (211) which has an arm (212) extending in the axial direction and provided with the hinging pin (213) arranged transversely with respect to the axial direction of the joint.

12. Joint according to Claims 1 and 10, characterized in that said hinge element (200) comprises a second block (311) forming the other hinge arm, which has formed inside it seats (312, 313) for housing said pin (213) and arm (212), axially locking means (314a, 314b) also being provided.

13. Joint according to Claims 1 and 10, characterized in that openings (315, 15) aligned with one another and designed to allow rotation of the arm (212) about the pin (213) are formed on the corresponding external surfaces of said second block (311) and the section of the body (1) in which the latter is inserted.
